Europäisches Patentamt

European Patent Office

Office européen des brevets

(11) Veröffentlichungsnummer: **0 367 885**

**A1**

# EUROPÄISCHE PATENTANMELDUNG

(21) Anmeldenummer: 88730245.3

(22) Anmeldetag: 08.11.88

(51) Int. Cl.⁵: **H05K 3/18, C23C 18/30**

(43) Veröffentlichungstag der Anmeldung:
**16.05.90 Patentblatt 90/20**

(84) Benannte Vertragsstaaten:
**BE CH DE ES FR GB IT LI LU NL SE**

(71) Anmelder: **SCHERING AKTIENGESELLSCHAFT**
**Berlin und Bergkamen**
**Müllerstrasse 170/178 Postfach 65 03 11**
**D-1000 Berlin 65(DE)**

(72) Erfinder: **Ehrich, Hans-Jürgen, Dr.**
**Ulmenallee 53**
**D-1000 Berlin 19(DE)**
Erfinder: **Mahlkow, Hartmut**
**Handjerystrasse 85**
**D-1000 Berlin 41(DE)**

(54) Konditionierungsmittel für gedruckte Schaltungen.

(57) Die Erfindung betrifft die Verwendung einer alkalischen Lösung enthaltend ein halogenfreies Palladiumsalz und 2-Aminopyridin als Konditionierungsmittel für Basismaterial zur Herstellung von gedruckten Schaltungen.

EP 0 367 885 A1

EP 0 367 885 A1

## KONDITIONIERUNGSMITTEL FÜR GEDRUCKTE SCHALTUNGEN

Die Erfindung betrifft die Verwendung einer alkalischen Lösung enthaltend ein halogenfreies Palladiumsalz und 2-Aminopyridin als Konditionierungsmittel für Basismaterial zur Herstellung von gedruckten Schaltungen.

Die Entwicklung auf dem Sektor der Leiterplattentechnik hat im Laufe der vergangenen Jahre einen stürmischen Aufschwung erfahren, der vor allem durch die Miniaturisierungstendenz gefördert wurde. Sie hat zu immer weiterer Schaltbildverdichtung geführt, die auf doppelseitigen Leiterplatten angetroffen wird, ihren bedeutsamsten Ausdruck aber in den immer komplexer werdenden Mehrlagenschaltungen findet. Schaltbildleiterzüge und Schaltebenen sind ganz eng aneinandergerückt und werden vielfach nur durch 80 - 150 $\mu$m weite Isolierabstände voneinander getrennt.

Dagegen ist im gleichen Entwicklungszeitraum das Basismaterial im Prinzip unverändert geblieben. Es besteht nach wie vor aus glasfaserverstärktem Epoxidharz, das mit Füllmaterialien zur Verfestigung und aus Gründen der Flammwidrigkeit versetzt ist. Es ergeben sich deshalb mit herkömmlichen Arbeitsmethoden wachsende Schwierigkeiten, die verbliebenen dünnen Isolationsschichten vom schädigenden Einfluß der z. T. aggressiven Medien zur chemischen Vorbehandlung und Metallisierung ganz frei zu halten. Waren die Abstände in früheren Schaltungen so bemessen, daß Randeinwirkungen toleriert werden konnten, so steht dazu bei hochminiaturisierten, raumsparend ausgeführten modernen Schaltungen kein Platz mehr zur Verfügung. Lösungen, die nicht nur die Bearbeitungsoberfläche beeinflussen, sondern unkalkulierbar in das Innere des Materials hineinwirken, mindern die Isolationswirkung zwischen den Bohrlöchern beziehungsweise zwischen Bohrloch und Schaltungsebene, und bedrohen die gesamte elektrische Funktion der immer kostspieligeren Schaltung.

Im Rahmen der Konditionierung als Vorbereitung zur Metallisierung spielt der Aktivator eine zentrale Rolle. Durch ihn werden auf der zu metallisierenden Isolatoroberfläche des Bohrloches Palladiumpartikel adsorbiert, die Keimpunkte der folgenden chemischen Metallisierung sind. Üblicherweise spielt sich dieser Prozeß in stark salzsaurer Palladiumchlorid und Zinn-II-chlorid versetzter Lösung ab, in der unter Oxidation des 2-wertigen zu 4-wertigem Zinn die Reduktion zu elementarem Palladium erfolgt.

Nun geht vom salzsauren Medium, wie überhaupt von halogenhaltigen Lösungen, eine schwerwiegend schädigende Wirkung aus, die inzwischen unter den Bezeichnungen "wicking" (Dochtbildung) beziehungswiese "replating" (Rückverkupferung) bekannt geworden ist. Sie wird auf die Tatsache zurückgeführt , daß durch Salzsäure und andere Halogenide jene Brücken der Glasschlichte in Umkehrung ihrer Entstehung wieder zerstört werden, die den Verbund zwischen Glas und Harz im Basismaterial herstellen. Es entsteht eine Kapillare, in der die halogenhaltige Lösung längs der Glasfaser vordringt, sodaß diese dochtartig aus dem Harz herausragt. Gleichzeitig wird die Aktivierung tief in das Materialinnere vorgetragen, sodaß auch "rückwärts", also auch hinter der Behandlungsoberfläche, Verkupferung einsetzt. Je aufwen-diger der Basismaterialtyp mit Glasgewebe ausgestattet ist, desto größer muß die schädigende Wirkung sein.

Ein weiterer Nachteil geht auch von den Zinnverbindungen aus: bei längerer Aktivierungsdauer, wie sie mit Rücksicht auf die auf Glas nur zögernd einsetzenden Belegung erforderlich ist, wird das Kupfer der Stirnfront einer angeschnittenen Innenlage "überaktiviert". Durch hydrolysiernde Zinnverbindungen, die ihrerseits wegen ihrer schleimigen Konsistenz auf der Oberfläche haften, wird diese Zone mit besonders vielen Palladiumkeimen belegt, so daß sich eine inhibierende Schicht ausbildet, die einen festen Verbund von Innenlage und Metallhülse des Bohrloches verhindert. Sie ist die Ursache für eine Trennung (post separation) nach der thermischen Belastung des Lötens.

Sind zur Verbesserung der Isolationseigenschaften dem Epoxidharz Zwischenlagen aus Polyimid eingezogen, wie das zunehmend für starr/flexible Schaltungen typisch ist, dann kann im sauren, halogenhaltigen Medium keinerlei Haftung erwartet werden, weil Polyimid im unteren pH-Bereich vollkommen indifferent ist.

Diese Nachteile müssen vollständig vermieden werden.

Denn nur wenn die Ätherbrücken der Glasschlichte nicht angegriffen werden, bleibt der Verbund Glas/Harz voll erhalten und damit der elektrische Isolationswiderstand innerhalb der Leiterplatte. Das Gleiche gilt für die Delaminierung, d.h. Kupferoxid darf nicht angelöst werden. Schließlich soll auch das als Zwischanlagenmaterial immer mehr an Bedeutung zunehmende Polyimid in den gleichen Konditionierungsmechanismus einbezogen werden können.

Die Erfindung hat die Aufgabe, ein stabiles Konditionierungsmittel unter Vermeidung von Halogeniden zu schaffen, welches Palladium im alkalischen Medium enthält und ein ausgeprägtes Adsorptionsvermögen für alle Basismaterialien mit Ausnahme von Kupfer aufweist.

Diese Aufgabe wird durch die Verwendung einer alkalischen Lösung gemäß dem kennzeichnenden Teil

2

des Patentanspruchs gelöst.

Vorteilhafte Ausführungsformen sind in den Unteransprüchen beschrieben.

Das erfindungsgemäß zu verwendende Konditionierungsmittel enthält einen Komplexbildner für Palladium, der das Metall überraschenderweise im alkalischen Medium hervoragend komplexiert und über ein fast spezifisches Adsorptionsvermögen für gebohrtes Basismaterial einschließlich Glas verfügt, ausgenommen Kupfermetall.

Dieses Konditionierungsmittel eignet sich daher in einzigartiger Weise zur Vorbehandlung des Basismaterials und insbesondere der Bohrlöcher zum Zwecke der Durchkontaktierung und des Aufbaus von Leiterbahnen für gedruckte Schaltungen.

Der adsorbierende Komplex wird nach seiner Aufbringung durch Reduktion zerstört, was vorteilhafterweise durch Verwendung eines Reduktionsmittels auf Basis von Dimethylaminoboran oder Natriumborhydrid erfolgt.

Der Komplex zerfällt hierbei in wasserlösliche Bestandteile und läßt metallische Palladiumpartikel von etwa atomarer Größenordnung zurück. Eine sogenannte Überaktivierung der geschilderten Art ist demzufolge ausgeschlossen. Überraschenderweise ist die Adsorption auf Kupfer ausgeschlossen und es haften keine Begleitstoffe, da diese als wasserlösliche Komponenten leicht fortgespült werden.

Das erfindungsgemäß zu verwendende Konditionierungsmittel überwindet also alle Nachteile, die bei der Anwendung der konventionellen Arbeitsweise hingenommen werden müssen. Wegen des Fehlens der Salzsäure ist die Anwendung gefahrlos, er wirkt nicht korrosiv und seine analytische Überwachung beschränkt sich auf die Palladium-Bestimmung.

Konzepte der nahen Zukunft sehen Fertigungslinien vor, in denen die Leiterplatten horizontal über Schwalldüsen hinweggeführt werden, aus denen kontinuierlich die verschiedenen Behandlungslösungen mit hoher Geschwindigkeit austreten. Der zwangsläufig innige Kontakt mit der Luft verbietet den Einsatz oxidationsempfindlicher Aktivatoren, deren Zinn-2-Verbindungen laufend zu solchen des 4-wertigen Zinns oxidiert und damit unwirksam werden.

Das erfindungsgemäße anzuwendende Konditionierungsmittel ist demgegenüber völlig oxidationsunempflindlich und für Einsätze im Schwall- oder Spritzverfahren gleichermaßen bestens geeignet.

Die Konditionierung des Basismaterials erfolgt in an sich bekannter Weise.

Die Platten werden gesäubert, von Harzverschmierungen in den Bohrlöchern befreit und mit einer alkalischen oder sauren Behandlungslösung gereinigt, dann gespült und außerdem gewünschtenfalls noch einer Ätzreinigung unterworfen.

Dann erfolgt die erfindungsgemäße Konditionierung.

Die Grundzusammensetzung der erfindungsgemäßen zu verwendenden wässrigen Lösung ist wie folgt:
0.08 bis 0,2 g/Liter, vorzugsweise 0,15 g/Liter
Palladium in Form des halogenfreien Salzes, zum Beispiel des Sulfats.
1,5 bis 2,5 g/Liter, vorzugsweise 1,8 g/Liter,
2-Aminopyridin und
5 bis 10 g/Liter,
Alkalihydroxid, zum Beispiel Natriumhydroxid.
Die Lösung kann zusätzlich mindestens 40 g/Liter, vorzugsweise 60 g/Liter, Borsäure enthalten.
Der pH-Wert beträgt 10 - 13, vorzugsweise 10,5.
Als Reduktionsmittel lassen sich mit besonderem Vorteil Dimethylaminoboran und Natriumborhydrid verwenden, und zwar in Konzentrationen von 0,5 bis 2 g/Liter, vorzugsweise 1,0 g/Liter.

Zur chemischen und gegebenenfalls galvanischen Metallisierung lassen sich die hierfür bekannten Bäder in an sich bekannter Weise verwenden.

Die erfindungsgemäß hergestellten gedruckten Schaltungen finden Verwendung in der Elektrotechnik.

Das folgende Beispiel dient zur Erläuterung der Erfindung.

## BEISPIEL

Zunächst wird nach einem üblichen Verfahren im Falle von Mehrlagenschaltungen die Harzverschmierung aus den Bohrlöchern entfernt. Anschließend durchlaufen sie, ebenso wie die doppelseitigen Leiterplatten den folgenden Arbeitsablauf:

EP 0 367 885 A1

| | | |
|---|---|---|
| -Reinigen in einem üblichen Badtyp der alkalisch eingestellt wird. (pH: 13) | 4 - 6 min | 40 - 65°C |
| - Spülen | | |
| -Reinigen in einem üblichen Badtyp, der sauer eingestellt wird. (pH: 1) | 4 - 6 min | 25 - 30°C |
| - Spülen | | |
| - Ätzreinigen zur Säuberung der Kupferoberfläche in einem üblichen Ätzreinigungsbad | 1 - 2 min | RT |
| - Vortauchen in einem Vortauchbad, das den Aktivator vor Einschleppung von Fremdionen schützen und den pH-Wert stabilisieren soll | 1 - 2 min | RT |
| - Konditionieren mir der erfindungsgemäßen Lösung | 4 - 6 min | 30 - 40°C |

mit 2,47 g einer Palladiumstammlösung aus

| | |
|---|---|
| 4 Gew.% | Palladium |
| 36,6 Gew.% | Schwefelsäure 96%ig |
| 59,4 Gew.% | Wasser und |
| 0,09 g | 2-Aminopyridin |
| 3,00 g | Borsäure 99,5 %ig |
| 94,44 g | Wasser |

2,3 kg (2 l) dieses Konzentrats wird zur Betriebsaufnahme unter ständigem Rühren in eine Lösung von 60 g Natriumhydroxid in 7,6 l Wasser eingetragen und schließlich mit weiterem Natriumhydroxid oder Schwefelsäure auf pH 10,5 eingestellt.

| | | |
|---|---|---|
| - Spülen | | |
| - Reduzieren in einem auf den Aktivator abgestimmten Reduktor | 4 - 6 min | 30°C |
| bestehend aus | | |
| 11,0 g Dimethylaminoboran 89,0 g Wasser | | |

10 g dieses Konzentrats werden zur Betriebsaufnahme unter Rühren in eine Lösung von 50 g Natriumhydroxid in 9,8 l Wasser eingetragen. pH - Wert: 12
- Tauchen in eine 10 %ige, verdünnte Reduktorlösung
- Chemisches Verkupfern in einem üblichen Badtyp zur Erzeugung einer ersten geschlossenen Kupfersicht
Zwei so konditionierte Bohrlöcher mit einem Kleinstabstand von 190 μm weisen einen dem Materialtyp entsprechenden Höchstisolationswert von $10^5$ MΩauf.

## Ansprüche

1. Verwendung einer alkalischen Lösung enthaltend ein halogenfreies Palladiumsalz und 2-Aminopyridin als Konditionierungsmittel für Basismaterial zur Herstellung von gedruckten Schaltungen.
2. Verwendung einer Lösung gemäß Anspruch 1 enthaltend Palladiumsulfat und 2-Aminopyridin.
3. Verwendung einer Lösung gemäß Anspruch 1 mit einem ph-Wert von 10 bis 13, vorzugsweise 10,5.
4. Verwendung einer Lösung gemäß Anspruch 1 enthaltend zusätzlich Borsäure.
5. Verwendung einer Lösung gemäß Anspruch 1 enthaltend 0,08 bis 0,2 g/Liter, vorzugsweise 0,15 g/Liter Palladium in Form des Palladiumsalzes und 1,5 bis 2,5 g/Liter, vorzugsweise 1,8 g/Liter, 2-Aminopyridin.

4

6. Verwendung einer Lösung gemäß Ansprüchen 1 bis 5, dadurch gekennzeichnet, daß die Bohrlöcher nach erfolgter Konditionierung mit einem Reduktionsmittel auf Basis einer alkalischen Lösung von Dimethylaminoboran oder Natriumborhydrid behandelt und dann chemisch metallisiert werden.

7. Verwendung einer Lösung gemäß Ansprüchen 1 bis 6 zur Herstellung von gedruckten Schaltungen.

8. Alkalische Lösung enthaltend ein halogenfreies Palladiumsalz und 2-Aminopyridin zur Konditionierung von Basismaterial zur Herstellung von gedruckten Schaltungen.

9. Alkalische Lösung gemäß Anspruch 8 zur Konditionierung der Bohrlöcher in Basismaterial.

10. Alkalische Lösung gemäß Anspruch 8 zur Konditionierung der Bohrlöcher in Basismaterial für den Einsatz in Schwall- oder Spritzverfahren.

11. Gedruckte Schaltungen behandelt mit einer alkalischen Lösung enthaltend ein halogenfreies Palladiumsalz und 2-Aminopyridin.

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | EP-A-0 156 987 (SHERING AG)<br>* Beispiel; Ansprüche 4,5 *<br>--- | 1,2,6-9<br>,11 | H 05 K 3/18<br>C 23 C 18/30 |
| Y | FR-A-2 132 172 (SCHERING AG)<br>* Seite 1, Zeilen 28-34; Seite 2,<br>Zeilen 1-30; Seite 4, Zeile 22; Seite<br>6, Zeilen 17-22; Seite 9, Zeilen 14-38;<br>Beispiel 5 *<br>--- | 1,2,6-9 | |
| A | US-A-4 182 784 (MacGEAN CHEMICAL CO.)<br>* Spalte 1, Zeilen 34-67; Anspruch 1 *<br>--- | 1,2,7 | |
| E | EP-A-0 317 092 (OMI INTERNATIONAL<br>CORP.)<br>* Seite 3, Zeilen 12-29,41-44; Seite 4,<br>Zeile 22 - Seite 5, Zeile 19; Seite 6,<br>Zeilen 46-51; Seite 7, Zeilen 25-33;<br>Beispiel 17 *<br>----- | 1,3-9,<br>11 | |

RECHERCHIERTE SACHGEBIETE (Int. Cl.5)

H 05 K
C 23 C

Der vorliegende Recherchenbericht wurde für alle Patentansprüche erstellt

| Recherchenort | Abschlußdatum der Recherche | Prüfer |
|---|---|---|
| DEN HAAG | 03-07-1989 | SCHUERMANS N.F.G. |